# EUROPÄISCHE PATENTSCHRIFT

(11) **EP 2 931 792 B1**
(45) Veröffentlichungstag und Bekanntmachung des Hinweises auf die Patenterteilung: **06.04.2016**
(21) Anmeldenummer: 13791999.9
(22) Anmeldetag: 15.11.2013
(51) Int. Cl.: C08J 5/18, C08L 83/04, B29C 47/00

(54) **HERSTELLUNG DÜNNER SILICONFOLIEN**
PRODUCTION OF THIN SILICONE FILMS
PRODUCTION DE FILMS MINCES DE SILICONE

(30) Priorität: 12.12.2012 DE 102012222992
(43) Veröffentlichungstag der Anmeldung: 21.10.2015
(73) Patentinhaber: Wacker Chemie AG, 81737 München (DE)
(72) Erfinder: KÖLLNBERGER, Andreas, 84375 Kirchdorf (DE); SCHWINGHAMMER, Alfred, 84347 Pfarrkirchen (DE)
(74) Vertreter: Mieskes, Klaus Theoderich
(86) Internationale Anmeldenummer: PCT/EP2013/073914
(87) Internationale Veröffentlichungsnummer: WO 2014/090506

(56) Entgegenhaltungen:
- EP-A1- 0 097 313
- EP-A1- 1 535 965
- EP-A1- 2 110 590
- EP-A2- 1 661 686
- WO-A1-03/038221
- DE-A1- 2 045 558
- DE-A1- 2 408 659
- DE-A1-102006 028 901
- SHAHRZAD JALALI MAZLOUMAN ET AL: "Mechanically reconfigurable antennas using electro-active polymers (EAPs)", ANTENNAS AND PROPAGATION (APSURSI), 2011 IEEE INTERNATIONAL SYMPOSIUM ON, IEEE, 3. Juli 2011 (2011-07-03), Seiten 742-745, XP032191527, DOI: 10.1109/APS.2011.5996819 ISBN: 978-1-4244-9562-7

## Beschreibung

Die vorliegende Erfindung betrifft ein Verfahren zur kontinuierlichen Herstellung dünner Siliconfolien, wobei die Foliendicke zwischen 0,1 und 200 µm liegt und die Dickengenauigkeit ±5 % gemessen auf einer Fläche von 200 cm² beträgt.

EP0097313A1 beschreibt die Herstellung eines dünnen Siliconelastomerfilms mit einer Foliendicke von einem bis 500 µm. Für die Herstellung wird der Film auf ein beschichtetes Papier aufgebracht. Hierzu werden die Beschichtungstechniken Rollenbeschichtung, Luftrakel oder Reverse Roll coating, Wirewound bar coating oder Sprüh coating zur Herstellung dünner Folien verwendet. Diese Techniken führen zu Siliconfolien mit einer unbefriedigenden Dickengenauigkeiten und sind daher nur begrenzt einsetzbar.

In DE2408659 wird ein Verfahren zur Herstellung dünner, fehlerfreier Siliconfolien beschrieben, wobei der Siliconfilm durch gießen einer zentrifugierten, mit Lösungsmittel versehenen Siliconmasse hergestellt wird. Das aufwändige Verfahren ist jedoch zur industriellen Herstellung in einem kontinuierlichen Prozess nicht geeignet. Zudem werden durch den beschriebenen Gießprozesse ebenfalls nur unzureichende Dickengenauigkeiten erreicht.

EP1661686A2 beschreibt die Extrusion, bzw. Co-Extrusion einer Siliconschicht. Für Schichtdicken unterhalb von etwa 200 µm sind Extrusionsprozesse hinsichtlich der Dickengenauigkeit nicht geeignet, was einen wesentlichen Nachteil dieser Technologie darstellt. Durch die Verwendung eines Trägermaterials bei der Extrusion werden zudem die Dickenschwankungen des Trägers auf die Siliconfolie übertragen.

Ein kontinuierliches Verfahren zur Herstellung dünner Siliconfolien wird in DE2045558 beschrieben. Die Hauptnachteile dieses Verfahrens bestehen darin, dass die Rakelbeschichtung zum einen hohe Lösungsmittelgehalte (beschrieben wurden idealerweise 60 Gew.%) erfordert und zum anderen ist die Genauigkeit der Schichtdicke, analog zu Extrusionsverfahren, von der Präzision des verwendeten Trägers abhängig.

Wie der Stand der Technik zeigt, können Siliconfolien in einem Dickenbereich ab etwa 200 µm bis zu mehreren mm durch Extrusions- oder Moldingverfahren hergestellt werden. Dabei zeigen die jeweiligen Verfahren unterschiedliche Nachteile. Bei diskontinuierlichen Moldingverfahren geht eine Verminderung der Schichtdicke mit Problemen beim automatischen Entformen einher, zudem sind die Produktionskosten je Quadratmeter (qm) Folie höher als bei kontinuierlich arbeitenden Prozessen. Extrusionsverfahren von HTV-Kautschuken haben den Nachteil größerer Dickenvarianzen sowie die durch Anlagenauslegung und Schlitzquellung begrenzte Möglichkeit der Schichtdickenverringerung unter 200 µm Schichtdicke.

Neben der absoluten Schichtdicke ist die Gleichmäßigkeit der Schichtdicke über die gesamte produzierte Bahn ein entscheidender Faktor für Anwendungen der Folie beispielsweise als Dielektrikum oder als Membran. Der Bedarf sehr gleichmäßiger Folien mit Dicken zwischen einem und ca. 250 µm ist vor allem bei der Entwicklung von dielektrischen elektroaktiven Polymeren (kurz EAP) gegeben, bei denen die Folie als Dielektrikum verwendet wird. Anwendungen der elektroaktiven Polymere in Aktoren, Sensoren oder Generatoren basieren darauf, elektrische in mechanische Energie oder mechanische in elektrische Energie zu wandeln. Nach Aufbringen einer elektrisch leitenden Beschichtung auf einer oder beiden Seiten der Folie wird zum Beispiel durch Anlegen von elektrischer Spannung eine Verformung des Gesamtsystems hervorgerufen (Prinzip des Aktors).

Aufgabe war daher die Bereitstellung eines kontinuierlichen Verfahrens zur Herstellung dünner Siliconfolien, mit sehr dünner und sehr gleichmäßiger Schichtdicke, sowie mit hoher Oberflächengüte und hoher Dauerbelastungsbeständigkeit.

Überraschenderweise wird diese Aufgabe gelöst vom erfindungsgemäßen Verfahren zur kontinuierlichen Herstellung dünner Siliconfolien mit einer Foliendicke von 0,1 bis 200 µm, und einer Dickengenauigkeit von ±5 % gemessen auf einer Fläche von 200 cm²,
dadurch gekennzeichnet, dass
i) eine lösungsmittelhaltige oder lösungsmittelfreie, vernetzbare Siliconzusammensetzung (X) durch den Spalt einer Schlitzdüse auf einen sich bewegenden Träger aufgetragen wird,
ii) anschließend aus der Siliconschicht, welche sich auf der Trägerfolie ausbildet das Lösungsmittel, falls vorhanden, entfernt und die Siliconschicht vernetzt wird,
iii) nach der Vernetzung die entstandene Siliconfolie vom Träger getrennt werden kann,
mit folgenden Maßgaben:
- die Schlitzdüse in Schritt i) steht in einem Winkel zwischen 10° und 90° zum Träger;
- die Laufgeschwindigkeit des Trägers liegt zwischen 0,1 und 1000m/min;
- die dynamische Viskosität gemessen nach DIN53019 der Siliconzusammensetzung (X) liegt zwischen 100mPa•s und 100Pa•s.

Die im Folgenden an unterschiedlichen Textstellen offenbarten bevorzugten Ausführungsformen einzelner Merkmale der vorliegenden Erfindung sind dahingehend zu verstehen, dass auch die Kombinationen dieser Merkmale in ihren bevorzugten Ausführungsformen besonders bevorzugt sind.

Das erfindungsgemäße Verfahren wird möglichst unter Partikelfreiheit durchgeführt. Partikelfreiheit bedeutet, dass beim Gesamtprozess der Folienherstellung darauf geachtet werden muss, dass möglichst wenig Partikel, ob nun aus eventuell eingemischten aktiven oder inaktiven Füllstoffen, oder als Fremdpartikel, enthalten sind, welche größer sind, als etwa 1/3 der gewünschten Schichtdicke. Beispielsweise sind in einer 24 µm dicken, erfindungsgemäßen Siliconfolie vorzugsweise keine Partikel enthalten, deren Durchmesser 8µm übersteigt. Das Entfernen von eventuell enthaltenen Partikeln aus der Siliconzusammensetzung (X) kann prinzipiell durch alle Techniken erfolgen, die dem Stand der Technik bekannt sind. Beispiele hierfür sind Strainern über Strainersiebe (Drahtnetze, Drahtgeflecht), Filterkerzen aus den verschiedensten Materialien (Metall, Kunststoff, Keramik, etc.), Filtrationstechniken wie z.B. Magnetfiltration, Druckfiltration über Filterpressen, Rückspülfilter, Drucknutschen, etc. mit oder ohne Filterhilfen wie Aktivkohle, Metalloxide, etc. Ein weiteres Beispiel für die Entfernung von Partikeln aus der Siliconzusammensetzung (X) ist die Zentrifugation, wobei alle genannten oder möglichen Verfahren im Batch-Prozess oder kontinuierlich erfolgen können.

Das Verfahren zur Herstellung der Siliconfolie aus der Siliconzusammensetzung (X) erfolgt vorzugsweise unter Reinraumbedingungen, bei denen Partikel größer 5 µm nicht vorkommen. Für die Auslegung der Produktionsanlage bedeutet das, dass die unvernetzte Siliconzusammensetzung (X) nach der Entfernung eventuell enthaltener Partikel nur in Reinräumen der Klasse ISO 5 (ISO 1466-1) und besser gelagert und verarbeitet wird, bevorzugt in Reinräumen der Klasse ISO 4 und besser.

Das als Träger verwendete Trägermaterial spielt für die Herstellung der Siliconfolie eine untergeordnete Rolle. Lediglich die Oberflächengüte ist entscheidend, da Erhebungen oder Vertiefungen der Oberfläche direkt von der Siliconzusammensetzung (X) abgeformt werden. Vorzugsweise werden aus diesem Grund Trägermaterialien verwendet, deren Oberflächen besonders glatt sind und keine Vertiefungen oder Erhebungen enthalten, die größer als 5% bevorzugt 3% der herzustellenden Foliendicken sind. Beispiele für Trägermaterialien sind: Polyethlyen, Polypropylen, Polyvinylchlorid, Polystyrol, Cellophan, Polyester (Polyethylenterephthalat, Polybutylenterephthalat, Polycarbonat, Polyethylennaphtalat), Fluor-haltige Polymere (Polytetrafluorethylen), Metallbänder oder -folien (als Endlosband oder über die skizzierten Vorlagerollen, es sind alle Metalle möglich, mit oder ohne Oberflächenbeschichtung). Die Dicke des verwendeten Trägermaterials spielt ebenfalls nur eine untergeordnete Rolle. Bevorzugte Dicken für Kunststoffträger oder Metallfolien betragen 10µm bis 200µm, für Metallbänder 200µm bis 2mm. Bevorzugte Trägermaterialien sind Metallfolien, Metallbänder und Kunststofffolien aus Polyethylen, Polypropylen, Polyethylenterephthalat, Polybutylenterephthalat sowie Polytetrafluoroethylen.

Die Laufgeschwindigkeit des Trägers zur Produktion der Siliconfolien liegt üblicherweise zwischen 0,1 und 1000 m/min, bevorzugt zwischen 0,5 und 500 m/min und besonders bevorzugt zwischen 1 und 250 m/min. Mit dem erfindungsgemäßen Verfahren können Bahnbreiten zwischen wenigen Zentimetern und mehreren Metern erreicht werden, wobei die bevorzugte Breite zwischen 10cm und 4m liegt, besonders bevorzugt zwischen 20cm und 3m.

Durch die Verwendung einer Schlitzdüse ist die Dicke der produzierten Siliconschicht nur Abhängig vom Materialfluss, der über die zuführende Pumpe eingestellt wird, der Bahngeschwindigkeit und der Dichte der verwendeten vernetzbaren Siliconzusammensetzung (X). Die dynamische Viskosität gemessen nach DIN53019 der Siliconzusammensetzung (X) liegt zwischen 100 mPa•s und 100 Pa•s, bevorzugt zwischen 200 mPa•s und 75 Pa•s und besonders bevorzugt zwischen 300 mPa•s und 50 Pa•s. Schlitzdüsen sind dem Fachmann aus dem Stand der Technik bekannt.

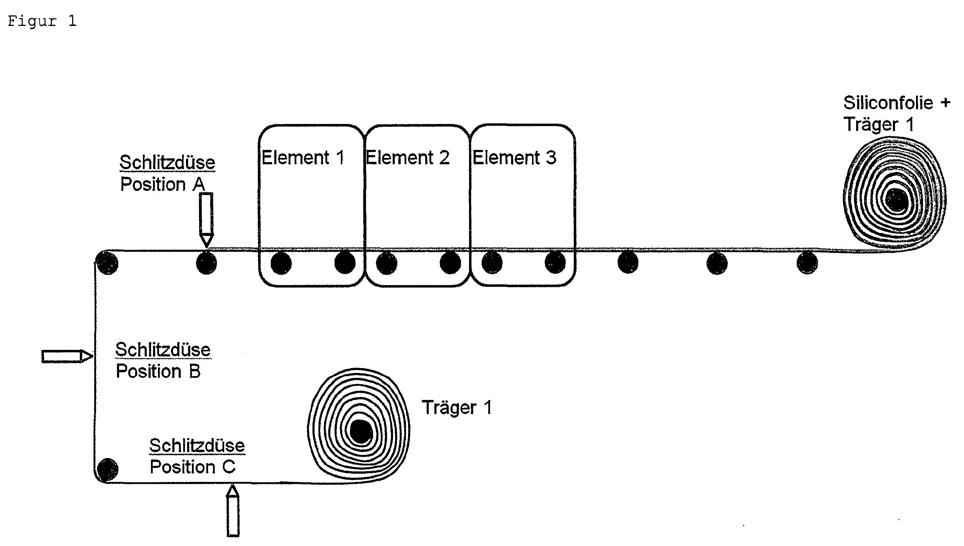

Im Folgenden werden mehrere Ausführungsformen des erfindungsgemäßen Verfahrens beispielhaft anhand von Figur 1 bis Figur 4 beschrieben. Diese sind jedoch nicht als abschließend für die Ausgestaltungsformen des erfindungsgemäßen Verfahrens zu verstehen.

In einer einfachen Ausführungsform erfolgt die Herstellung der erfindungsgemäßen Siliconfolien auf einer Produktionsanlage nach Figur 1.

Figur 1 dient der einfachen Veranschaulichung des erfindungsgemäßen Verfahrens. Bei einer Anordnung wie in Figur 1 dargestellt, wird die Siliconfolie dadurch erzeugt, dass die unvernetzte Siliconzusammensetzung (X) durch den Spalt der Schlitzdüse in Schritt i) gefördert wird, wobei die Fördermenge und die Geschwindigkeit des Trägers so anzupassen sind, dass die gewünschte Schichtdicke daraus resultiert. Die Spaltöffnung am Kopf der Schlitzdüse ist üblicherweise im Breiten-Bereich der herzustellenden Schicht, wobei auch deutliche Unterschiede möglich sind (wie auch aus den späteren Beispielen ersichtlich ist). Der Abstand der Schlitzdüse zum Träger liegt etwas über der gewünschten Schichtdicke der Folie. Für eine 50 µm dicke Siliconfolie kann der Abstand beispielsweise zwischen der Schlitzdüse und dem Träger zwischen 55 µm und 500 µm variieren. Bevorzugt liegt der Abstand bei einer 50 µm Folie zwischen 55 µm und 350 µm und besonders bevorzugt zwischen 55 µm und 200 µm.

Die Positionierung der Schlitzdüse zum Träger kann sowohl senkrecht von oben (Position A), horizontal (Position B) oder von unten (Position C) erfolgen. Der Winkel zwischen der Schlitzdüse und dem Trägermaterial beträgt in der Figur 1 90°, es sind jedoch andere Winkel wie weiter unten beschrieben möglich. In Figur 1 sind die Elemente 1 bis 3 abgebildet sie dienen für den Schritt ii). Ihre Anzahl ist lediglich als Beispiel und nicht beschränkend auf ihre Anzahl zu verstehen. Werden Siliconzusammensetzungen (X) verwendet, die kein Lösungsmittel enthalten, kann die Verwendung eines einzigen Elementes (beispielsweise für Heißluft, IR-Strahlung oder UV-Strahlung) ausreichend sein, um die Vernetzung im Schritt ii) zur Siliconfolie zu bewirken. Bei Siliconzusammensetzungen (X), die Lösungsmittel enthalten, ist es von Vorteil, wenn im Prozessschritt ii) die Entfernung des Lösungsmittels und der Vernetzungsschritt zur Siliconfolie getrennt werden, dafür werden mindestens zwei Elemente, Element 1 und Element 2 benötigt. Es können jedoch auch mehrere Elemente in Kombinationen für Schritt ii) eingesetzt werden. Beispielsweise dient in Figur 1 Element 1 dem Ablüften von Lösungsmittel, Element 2 dient der Vernetzung und Element 3 dient der Nachbehandlung. Nachdem die Siliconfolie ausgehärtet ist, wird sie in Figur 1 zusammen mit dem Träger gesammelt bzw. aufgewickelt. Je nach Bahngeschwindigkeit und Anspringtemperatur der Siliconzusammensetzung (X) können die Längen der Ablüft-, Vernetzungs- und Nachbehandlungsstrecken der Elemente 1 bis 3 variieren.

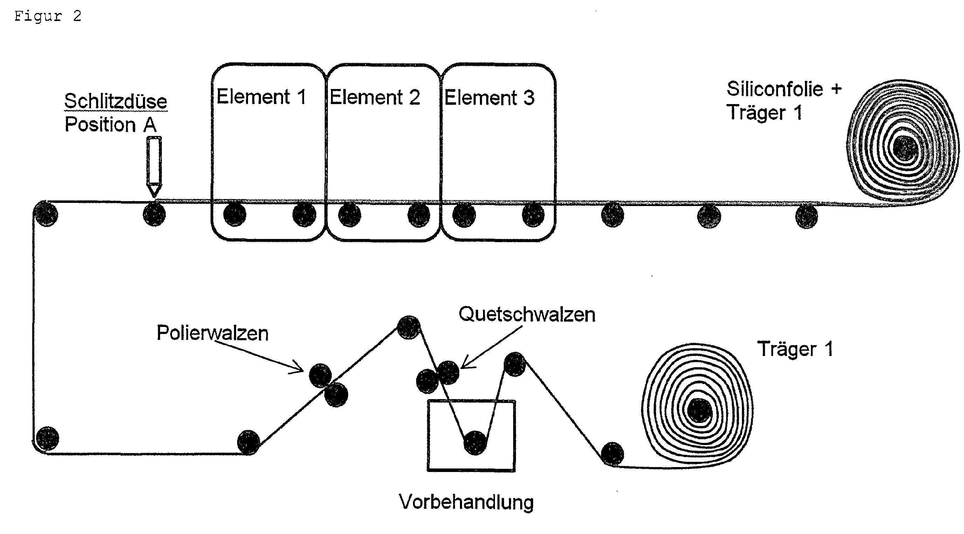

In Figur 2 erfolgt die Herstellung analog zu Figur 1 mit dem zusätzlichen Prozessschritt ia) einer Vorbehandlung des Trägers. Es handelt sich dabei um eine Tauchbehandlung des Trägers. Nach der Tauchbehandlung wird der Träger durch Quetsch- und Polierwalzen geführt um überschüssiges Vorbehandlungsmaterial zu entfernen.

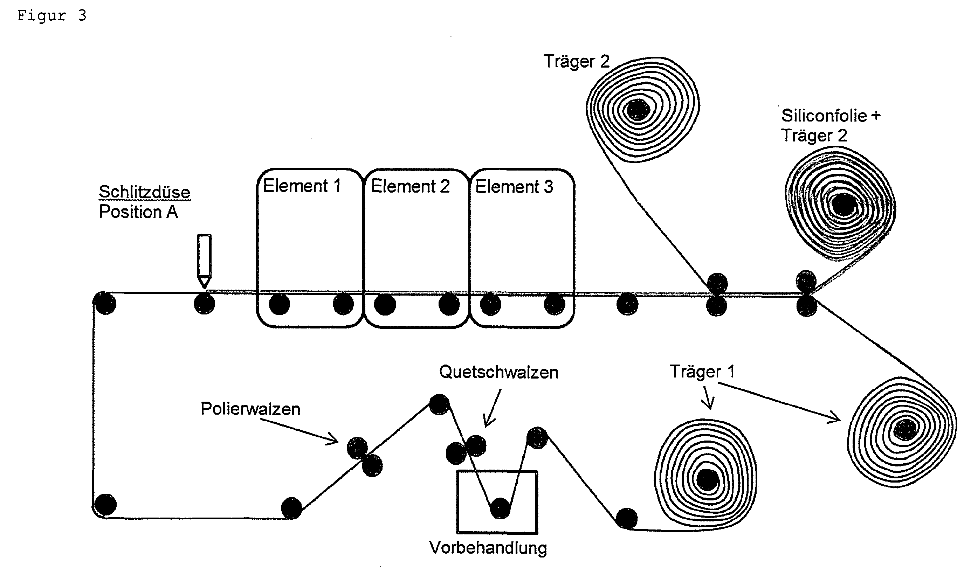

In Figur 3 erfolgt die Herstellung analog zu Figur 2 mit dem zusätzlichen Prozessschritt, der Verwendung eines zweiten Trägers Träger 2 im Schritt iii) nach der Vernetzung zur Siliconfolie. Hier wird der Träger 2 auf die Oberfläche der Siliconfolie gebracht und etwas versetzt (kann aber auch gleichzeitig erfolgen) wird die Siliconfolie von Träger 1 getrennt und zusammen mit Träger 2 gesammelt.

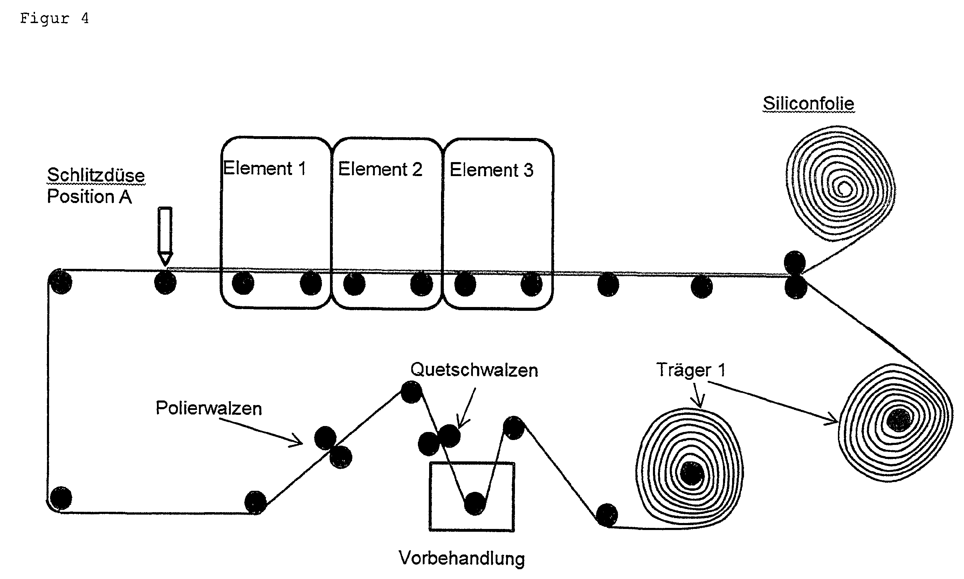

In Figur 4 erfolgt die Herstellung analog zu Figur 2 mit dem Unterschied dass die Siliconfolie direkt nach der Herstellung in Schritt ii) vom Träger als Schritt iii) getrennt wird und alleine gesammelt wird.

Als Siliconzusammensetzung (X) können im Prinzip alle dem Stand der Technik bekannten Silicone verwendet werden. Es können additionsvernetzende, peroxidisch vernetzende, kondensationsvernetzende oder strahlenvernetzende Zusammensetzungen verwendet werden. Bevorzugt sind peroxidisch oder additionsvernetzende Zusammensetzungen. Besonders bevorzugt sind additionsvernetzende Zusammensetzungen.

Erfindungsgemäß verwendete additionsvernetzende Siliconzusammensetzungen (X) sind im Stand der Technik bekannt und enthalten im einfachsten Fall
(A) mindestens eine lineare Verbindung, die Reste mit aliphatischen Kohlenstoff-Kohlenstoff-Mehrfachbindungen aufweist,
(B) mindestens ein lineares Organopolysiloxan mit Si-gebundenen Wasserstoffatomen,
oder anstelle von (A) und (B)
(C) mindestens ein lineares Organopolysiloxan, die SiC-gebundene Reste mit aliphatischen Kohlenstoff-Kohlenstoff Mehrfachbindungen und Si-gebundene Wasserstoffatome aufweist, und
(D) mindestens einen Hydrosilylierungskatalysator.

Bei den additionsvernetzenden Siliconzusammensetzungen (X) kann es sich um Einkomponenten-Siliconzusammensetzungen wie auch um Zweikomponenten-Siliconzusammensetzungen handeln.

Bei Zweikomponenten-Siliconzusammensetzungen können die beiden Komponenten der erfindungsgemäßen, additionsvernetzenden Siliconzusammensetzungen (X) alle Bestandteile in beliebiger Kombination enthalten, im Allgemeinen mit der Maßgabe, dass eine Komponente nicht gleichzeitig Siloxane mit aliphatischer Mehrfachbindung, Siloxane mit Si-gebundenem Wasserstoff und Katalysator, also im Wesentlichen nicht gleichzeitig die Bestandteile (A), (B) und (D) bzw. (C) und (D) enthält.

Die in den erfindungsgemäßen, additionsvernetzenden Siliconzusammensetzungen (X) eingesetzten Verbindungen (A) und (B) bzw. (C) werden bekanntermaßen so gewählt, dass eine Vernetzung möglich ist. So weist beispielsweise Verbindung (A) mindestens zwei aliphatisch ungesättigte Reste auf und (B) mindestens drei Si-gebundene Wasserstoffatome, oder Verbindung (A) weist mindestens drei aliphatisch ungesättigte Reste auf und Siloxan (B) mindestens zwei Si-gebundene Wasserstoffatome, oder aber anstelle von Verbindung (A) und (B) wird Siloxan (C) eingesetzt, welches aliphatisch ungesättigte Reste und Si-gebundene Wasserstoffatome in den oben genannten Verhältnissen aufweist. Auch möglich sind Mischungen aus (A) und (B) und (C) mit den oben genannten Verhältnissen von aliphatisch ungesättigten Resten und Si-gebundenen Wasserstoffatomen.

Die erfindungsgemäße additionsvernetzende Siliconzusammensetzung (X) enthält üblicherweise 30-95 Gew.%, bevorzugt 30-80 Gew.% und besonders bevorzugt 40-70 Gew.% (A). Die erfindungsgemäße additionsvernetzende Siliconzusammensetzung (X) enthält üblicherweise 0,1-60 Gew.%, bevorzugt 0,5-50 Gew.% und besonders bevorzugt 1-30 Gew.% (B). Falls die erfindungsgemäße additionsvernetzende Siliconzusammensetzung (X) die Komponente (C) enthält, sind üblicherweise 30-95 Gew.%, bevorzugt 30-80 Gew.%, besonders bevorzugt 40-70 Gew.% (C) in der Formulierung enthalten.

Bei der erfindungsgemäß eingesetzten Verbindung (A) kann es sich um siliciumfreie organische Verbindungen mit vorzugsweise mindestens zwei aliphatisch ungesättigten Gruppen sowie um Organosiliciumverbindungen mit vorzugsweise mindestens zwei aliphatisch ungesättigten Gruppen handeln oder auch um deren Mischungen.

Beispiele für siliciumfreie organische Verbindungen (A) sind, 1,3,5-Trivinylcyclohexan, 2,3-Dimethyl-1,3-butadien, 7-Methyl-3-methylen-1,6-octadien, 2-Methyl-1,3-butadien, 1,5-Hexadien, 1,7-Octadien, 4,7-Methylen-4,7,8,9-tetrahydroinden, Methylcyclopentadien, 5-Vinyl-2-norbornen, Bicyclo[2.2.1]hepta-2,5-dien, 1,3-Diisopropenylbenzol, vinylgruppenhaltiges Pölybutadien, 1,4-Divinylcyclohexan, 1,3,5-Triallylbenzol, 1,3,5-Trivinylbenzol, 1,2,4-Trivinylcyclohexan, 1,3,5-Triisopropenylbenzol, 1,4-Divinylbenzol, 3-Methyl-heptadien-(1,5), 3-Phenyl-hexadien-(1,5), 3-Vinyl-hexadien-(1,5) und 4,5-Dimethyl-4,5-diethyl-octadien-(1,7), N,N'-Methylen-bis-acrylsäureamid, 1,1,1-Tris(hydroxymethyl)-propan-triacrylat, 1,1,1-Tris(hydroxymethyl)propantrimethacrylat, Tripropylenglykol-diacrylat, Diallylether, Diallylamin, Diallylcarbonat, N,N'-Diallylharnstoff, Triallylamin, Tris(2-methylallyl)amin, 2,4,6-Triallyloxy-1,3,5-triazin, Triallyl-s-triazin-2,4,6(1H,3H,5H)-trion, Diallylmalonsäureester, Polyethylenglykoldiacrylat, Polyethylenglykol Dimethacrylat, Poly(propylenglykol)methacrylat.

Vorzugsweise enthalten die erfindungsgemäßen additionsvernetzende Siliconzusammensetzungen (X) als Bestandteil (A) mindestens eine aliphatisch ungesättigte Organosiliciumverbindung, wobei alle bisher in additionsvernetzenden Zusammensetzungen verwendeten, aliphatisch ungesättigten Organosiliciumverbindungen eingesetzt werden können, wie beispielsweise Silicon-Blockcopolymere mit Harnstoffsegmenten, Silicon-Blockcopolymere mit Amid-Segmenten und/oder Imid-Segmenten und/oder Ester-Amid-Segmenten und/oder Polystyrol-Segmenten und/oder Silarylen-Segmenten und/oder Carboran-Segmenten und Silicon-Pfropfcopolymere mit Ether-Gruppen.

Als Organosiliciumverbindungen (A), die SiC-gebundene Reste mit aliphatischen Kohlenstoff-Kohlenstoff-Mehrfachbindungen aufweisen, werden vorzugsweise lineare oder verzweigte Organopolysiloxane aus Einheiten der allgemeinen Formel (I)

R⁴aR⁵bSiO_{(4-a-b)/2} (I)

eingesetzt, wobei
R⁴ unabhängig voneinander, gleich oder verschieden, ein von aliphatischen Kohlenstoff-Kohlenstoff-Mehrfachbindungen freien, organischen oder anorganischen Rest,
R⁵ unabhängig voneinander, gleich oder verschieden einen einwertigen, substituierten oder nicht substituierten, SiC-gebundenen Kohlenwasserstoffrest mit mindestens einer aliphatischen Kohlenstoff-Kohlenstoff-Mehrfachbindung,
a 0, 1, 2 oder 3 ist, und
b 0, 1 oder 2 ist
   bedeuten,
mit der Maßgabe, dass die Summe a + b kleiner oder gleich 3 ist und mindestens 2 Reste R⁵ je Molekül vorliegen.

Bei Rest R⁴ kann es sich um ein- oder mehrwertige Reste handeln, wobei die mehrwertigen Reste, wie beispielsweise bivalente, trivalente und tetravalente Reste, dann mehrere, wie etwa zwei, drei oder vier, Siloxy-Einheiten der Formel (I) miteinander verbinden.

Weitere Beispiele für R⁴ sind die einwertigen Reste -F, -Cl, - Br, OR⁶, -CN, -SCN, -NCO und SiC-gebundene, substituierte oder nicht substituierte Kohlenwasserstoffreste, die mit Sauerstoffatomen oder der Gruppe -C(O)- unterbrochen sein können, sowie zweiwertige, beidseitig gemäß Formel (I) Si-gebundene Reste. Falls es sich bei Rest R⁴ um SiC-gebundene, substituierte Kohlenwasserstoffreste handelt, sind bevorzugte Substituenten Halogenatome, phosphorhaltige Reste, Cyanoreste, -OR⁶,-NR⁶-, -NR⁶₂, -NR⁶-C(O)-NR⁶₂, -C(O)-NR⁶₂, -C(O)R⁶, -C(O)OR⁶, -SO₂-Ph und -C₆F₅. Dabei bedeuten R⁶ unabhängig voneinander, gleich oder verschieden ein Wasserstoffatom oder einen einwertigen Kohlenwasserstoffrest mit 1 bis 20 Kohlenstoffatomen und Ph gleich dem Phenylrest.

Beispiele für Reste R⁴ sind Alkylreste, wie der Methyl-, Ethyl-, n-Propyl-, iso-Propyl-, n-Butyl-, iso-Butyl-, tert-Butyl-, n-Pentyl-, iso-Pentyl-, neo-Pentyl-, tert-Pentylrest, Hexylreste, wie der n-Hexylrest, Heptylreste, wie der n-Heptylrest, Octylreste, wie der n-Octylrest und iso-Octylreste, wie der 2,2,4-Trimethylpentylrest, Nonylreste, wie der n-Nonylrest, Decylreste, wie der n-Decylrest, Dodecylreste, wie der n-Dodecylrest, und Octadecylreste, wie der n-Octadecylrest, Cycloalkylreste, wie Cyclopentyl-, Cyclohexyl-, Cycloheptyl- und Methylcyclohexylreste, Arylreste, wie der Phenyl-, Naphthyl-, Anthryl- und Phenanthrylrest, Alkarylreste, wie o-, m-, p-Tolylreste, Xylylreste und Ethylphenylreste, und Aralkylreste, wie der Benzylrest, der α- und der ß-Phenylethylrest.

Beispiele für substituierte Reste R⁴ sind Halogenalkylreste, wie der 3,3,3-Trifluor-n-propylrest, der 2,2,2,2',2',2'-Hexafluorisopropylrest, der Heptafluorisopropylrest, Halogenarylreste, wie der o-, m- und p-Chlorphenylrest, -(CH₂)-N(R⁶)C(O)NR⁶₂, -(CH₂)ₒ-C(O)NR⁶₂, (CH₂)ₒ-C(O)R⁶, - (CH₂)ₒ-C(O)OR⁶,-(CH₂)ₒ-C(O)NR⁶₂, - (CH₂) -C (O) - (CH₂)pC(O)CH₃, - (CH₂)-O-CO-R⁶,-(CH₂) -NR⁶- (CH₂)p-NR⁶₂, - (CH₂)ₒ-O-(CH₂)ₚCH (OH) CH₂OH,-(CH₂)ₒ(OCH₂CH₂)ₚOR⁶, - (CH₂)ₒ-SO₂-Ph und - (CH₂)ₒ-O-C₆F₅, wobei R⁶ und Ph der oben dafür angegebenen Bedeutung entsprechen und o und p gleiche oder verschiedene ganze Zahlen zwischen 0 und 10 bedeuten.

Beispiele für R⁴ gleich zweiwertige, beidseitig gemäß Formel (I) Si-gebundene Reste sind solche, die sich von den voranstehend für Rest R⁴ genannten einwertigen Beispiele dadurch ableiten, dass eine zusätzliche Bindung durch Substitution eines Wasserstoffatoms erfolgt, Beispiele für derartige Reste sind - (CH₂)-, -CH(CH₃)-, -C(CH₃)₂-, -CH(CH₃)-CH₂-, -C₆H₄-, -CH(Ph)-CH₂-, -C(CF₃)₂-, -(CH₂)ₒ-C₆H₄-(CH₂)ₒ-, - (CH₂)ₒ-C₆H₄-C₆H₄-(CH₂)ₒ-,-(CH₂O)ₚ, (CH₂CH₂O)ₒ, (CH₂)ₒ-Oₓ-C₆H₄-SO₂-C₆H₄-Oₓ-(CH₂)ₒ-, wobei x 0 oder 1 ist, und Ph, o und p die voranstehend genannte Bedeutung haben.

Bevorzugt handelt es sich bei Rest R⁴ um einen einwertigen, von aliphatischen Kohlenstoff-Kohlenstoff-Mehrfachbindungen freien, SiC-gebundenen, gegebenenfalls substituierten Kohlenwasserstoffrest mit 1 bis 18 Kohlenstoffatomen, besonders bevorzugt um einen einwertigen, von aliphatischen Kohlenstoff-Kohlenstoff-Mehrfachbindungen freien, SiC-gebundenen Kohlenwasserstoffrest mit 1 bis 6 Kohlenstoffatomen, insbesondere um den Methyl- oder Phenylrest.

Bei Rest R⁵ kann es sich um beliebige, einer Anlagerungsreaktion (Hydrosilylierung) mit einer SiH-funktionellen Verbindung zugängliche Gruppen handeln.

Falls es sich bei Rest R⁵ um SiC-gebundene, substituierte Kohlenwasserstoffreste handelt, sind als Substituenten Halogenatome, Cyanoreste und -OR⁶ bevorzugt, wobei R⁶ die obengenannte Bedeutung hat.

Bevorzugt handelt es sich bei Rest R⁵ um Alkenyl- und Alkinylgruppen mit 2 bis 16 Kohlenstoffatomen, wie Vinyl-, Allyl-, Methallyl-, 1-Propenyl-, 5-Hexenyl-, Ethinyl-, Butadienyl-, Hexadienyl-, Cyclopentenyl-, Cyclopentadienyl-, Cyclohexenyl-, Vinylcyclohexylethyl-, Divinylcyclohexylethyl-, Norbornenyl-, Vinylphenyl- und Styrylreste, wobei Vinyl-, Allyl- und Hexenylreste besonders bevorzugt verwendet werden.

Das Molekulargewicht des Bestandteils (A) kann in weiten Grenzen variieren, etwa zwischen 10² und 10⁶ g/mol. So kann es sich bei dem Bestandteil (A) beispielsweise um ein relativ niedermolekulares alkenylfunktionelles Oligosiloxan, wie 1,2-Divinyltetramethyldisiloxan, handeln, jedoch auch um ein über kettenständige oder endständige Si-gebundene Vinylgruppen verfügendes hochpolymeres Polydimethylsiloxan, z.B. mit einem Molekulargewicht von 10⁵ g/mol (mittels NMR bestimmtes Zahlenmittel). Auch die Struktur der den Bestandteil (A) bildenden Moleküle ist nicht festgelegt; insbesondere kann die Struktur eines höhermolekularen, also oligomeren oder polymeren Siloxans linear, cyclisch, verzweigt oder auch harzartig, netzwerkartig sein. Lineare und cyclische Polysiloxane sind vorzugsweise aus Einheiten der Formel R⁴₃SiO_{1/2}, R⁵R⁴₂SiO_{1/2}, R⁵R⁴SiO_{1/2} und R⁴₂SiO_{2/2} zusammengesetzt, wobei R⁴ und R⁵ die vorstehend angegebene Bedeutung haben. Verzweigte und netzwerkartige Polysiloxane enthalten zusätzlich trifunktionelle und/oder tetrafunktionelle Einheiten, wobei solche der Formeln R⁴SiO_{3/2}, R⁵SiO_{3/2} und SiO_{4/2} bevorzugt sind. Selbstverständlich können auch Mischungen unterschiedlicher, den Kriterien des Bestandteils (A) genügender Siloxane eingesetzt werden.

Besonders bevorzugt als Komponente (A) ist die Verwendung vinylfunktioneller, im wesentlichen linearer Polydiorganosiloxane mit einer Viskosität von 0,01 bis 500 000 Pa•s, besonders bevorzugt von 0,1 bis 100 000 Pa•s, jeweils bei 25°C.

Als Organosiliciumverbindung (B) können alle hydrogenfunktionellen Organosiliciumverbindungen eingesetzt werden, die auch bisher in additionsvernetzbaren Zusammensetzungen eingesetzt worden sind.

Als Organopolysiloxane (B), die Si-gebundene Wasserstoffatome aufweisen, werden vorzugsweise lineare, cyclische oder verzweigte Organopolysiloxane aus Einheiten der allgemeinen Formel (III)

R⁴_{c}H_{d}SiO_{(4-c-d)/2} (III)

eingesetzt, wobei
R⁴ die oben angegebene Bedeutung hat,
c 0, 1, 2 oder 3 ist und
d 0, 1 oder 2 ist,
mit der Maßgabe, dass die Summe von c + d kleiner oder gleich 3 ist und mindestens zwei Si gebundene Wasserstoffatome je Molekül vorliegen.

Vorzugsweise enthält das erfindungsgemäß eingesetzte Organopolysiloxan (B) Si-gebundenen Wasserstoff im Bereich von 0,04 bis 1,7 Gewichtsprozent (Gew.%), bezogen auf das Gesamtgewicht des Organopolysiloxans (B).

Das Molekulargewicht des Bestandteils (B) kann ebenfalls in weiten Grenzen variieren, etwa zwischen 10² und 10⁶ g/mol. So kann es sich bei dem Bestandteil (B) beispielsweise um ein relativ niedermolekulares SiH-funktionelles Oligosiloxan, wie Tetramethyldisiloxan, handeln, jedoch auch um ein über kettenständig oder endständig SiH-Gruppen verfügendes hochpolymeres Polydimethylsiloxan oder ein SiH-Gruppen aufweisendes Siliconharz.

Auch die Struktur der den Bestandteil (B) bildenden Moleküle ist nicht festgelegt; insbesondere kann die Struktur eines höhermolekularen, also oligomeren oder polymeren SiH-haltigen Siloxans linear, cyclisch, verzweigt oder auch harzartig, netzwerkartig sein. Lineare und cyclische Polysiloxane (B) sind vorzugsweise aus Einheiten der Formel R⁴₃SiO_{1/2}, HR⁴₂SiO_{1/2}, HR⁴SiO₂₂ und R⁴₂SiO_{2/2} zusammengesetzt, wobei R⁴ die vorstehend angegebene Bedeutung hat. Verzweigte und netzwerkartige Polysiloxane enthalten zusätzlich trifunktionelle und/oder tetrafunktionelle Einheiten, wobei solche der Formeln R⁴SiO_{3/2}, HSiO_{3/2} und SiO_{4/2} bevorzugt sind, wobei R⁴ die vorstehend angegebene Bedeutung hat.

Selbstverständlich können auch Mischungen unterschiedlicher, den Kriterien des Bestandteils (B) genügender Siloxane eingesetzt werden. Besonders bevorzugt ist die Verwendung niedermolekularer SiH-funktioneller Verbindungen wie Tetrakis(dimethylsiloxy)silan und Tetramethylcyclotetrasiloxan, sowie höhermolekularer, SiH-haltiger Siloxane, wie Poly(hydrogenmethyl)siloxan und Poly(dimethylhydrogenmethyl)siloxan mit einer Viskosität bei 25°C von 10 bis 20 000 mPa•s, oder analoge SiH-haltige Verbindungen, bei denen ein Teil der Methylgruppen durch 3,3,3-Trifluorpropyl- oder Phenylgruppen ersetzt ist.

Bestandteil (B) ist vorzugsweise in einer solchen Menge in den erfindungsgemäßen vernetzbaren Siliconzusammensetzungen (X) enthalten, dass das Molverhältnis von SiH-Gruppen zu aliphatisch ungesättigten Gruppen aus (A) bei 0,1 bis 20, besonders bevorzugt zwischen 0,3 und 2,0 liegt.

Die erfindungsgemäß eingesetzten Komponenten (A) und (B) sind handelsübliche Produkte bzw. nach in der Chemie gängigen Verfahren herstellbar.

Anstelle von Komponente (A) und (B) können die erfindungsgemäßen Siliconzusammensetzungen Organopolysiloxane (C), die gleichzeitig aliphatische Kohlenstoff-Kohlenstoff-Mehrfachbindungen und Si-gebundene Wasserstoffatome aufweisen, enthalten. Auch können die erfindungsgemäßen Siliconzusammensetzungen alle drei Komponenten (A), (B) und (C) enthalten.

Falls Siloxane (C) eingesetzt werden, handelt es sich vorzugsweise um solche aus Einheiten der allgemeinen Formeln (IV), (V) und (VI)

R⁴_{f}SiO_{4/2} (IV)

R⁴_{g}R⁵SiO_{3-g/2} (V)

R⁴ₕHSiO_{3-h/2} (VI)

wobei
R⁴ und R⁵ die oben dafür angegebene Bedeutung haben
f 0, 1, 2 oder 3 ist,
g 0, 1 oder 2 ist und
h 0, 1 oder 2 ist,
mit der Maßgabe, dass je Molekül mindestens 2 Reste R⁵ und mindestens 2 Si-gebundene Wasserstoffatome vorliegen.

Beispiele für Organopolysiloxane (C) sind solche aus SiO_{4/2}, R⁴₃SiO_{1/2}-, R⁴₂R⁵SiO_{1/2}- und R⁴₂HSiO_{1/2}- Einheiten, sogenannte MP-Harze, wobei diese Harze zusätzlich R⁴SiO_{3/2}- und R⁴₂SiO-Einheiten enthalten können, sowie lineare Organopolysiloxane im Wesentlichen bestehend aus R⁴₂R⁵SiO_{1/2}-, R⁴₂SiO- und R⁴HSiO-Einheiten mit R⁴ und R⁵ gleich der obengenannten Bedeutung.

Die Organopolysiloxane (C) besitzen vorzugsweise eine durchschnittliche Viskosität von 0,01 bis 500 000 Pa•s, besonders bevorzugt 0,1 bis 100 000 Pa•s jeweils bei 25°C. Organopolysiloxane (C) sind nach in der Chemie gängigen Methoden herstellbar.

Als Hydrosilylierungskatalysator (D) können alle dem Stand der Technik bekannten Katalysatoren verwendet werden. Komponente (D) kann ein Platingruppenmetall sein, beispielsweise Platin, Rhodium, Ruthenium, Palladium, Osmium oder Iridium, eine metallorganische Verbindung oder eine Kombination davon. Beispiele für Komponente (D) sind Verbindungen wie Hexachloroplatin(IV)-säure, Platindichlorid, Platinacetylacetonat und Komplexe der besagten Verbindungen, die in einer Matrix oder einer kernschalenartigen Struktur eingekapselt sind. Zu den Platinkomplexen mit niedrigem Molekulargewicht der Organopolysiloxane gehören 1,3-Diethenyl-1,1,3,3-Tetramethyldisiloxan-Komplexe mit Platin. Weitere Beispiele sind Platinphosphitkomplexe oder Platinphosphinkomplexe. Für licht- oder UV-härtende Zusammensetzungen können beispielsweise Alkylplatinkomplexe wie Derivate von Cyclopentadienyltrimethylplatin(IV), Cyclooctadienyldimethylplatin(II) oder Diketonatokomplexe wie zum Beispiel Bisacetylacetonatoplatin(II) verwendet werden, um die Additionsreaktion mit Hilfe von Licht zu starten. Diese Verbindungen können in einer Harzmatrix eingekapselt sein.

Die Konzentration von Komponente (D) ist zum Katalysieren der Hydrosilylierungsreaktion der Komponenten (A) und (B) und (C) bei Einwirkung ausreichend, um die hier in dem beschriebenen Verfahren erforderliche Wärme zu erzeugen. Die Menge an Komponente (D) kann zwischen 0,1 und 1000 Teile pro Million (ppm), 0,5 und 100 ppm oder 1 und 25 ppm des Platingruppenmetalls betragen, je nach Gesamtgewicht der Komponenten. Die Härtungsrate kann gering sein, wenn der Bestandteil des Platingruppenmetalls bei unter 1 ppm liegt. Die Verwendung von mehr als 100 ppm des Platingruppenmetalls ist unwirtschaftlich oder setzt die Lagerstabilität der Siliconzusammensetzung (X) herab.

Die additionsvernetzende Siliconzusammensetzungen (X) können optional alle weiteren Zusatzstoffe enthalten, die auch bisher zur Herstellung von additionsvernetzbaren Zusammensetzungen eingesetzt wurden. Beispiele für verstärkende Füllstoffe (F), die als Komponente in den erfindungsgemäßen additionsvernetzende Siliconzusammensetzungen (X) eingesetzt werden können, sind pyrogene oder gefällte Kieselsäuren mit BET-Oberflächen von mindestens 50 m²/g sowie Ruße und Aktivkohlen wie Furnace-Ruß und Acetylen-Ruß, wobei pyrogene und gefällte Kieselsäuren mit BET-Oberflächen von mindestens 50 m²/g bevorzugt sind. Die genannten Kieselsäurefüllstoffe können hydrophilen Charakter haben oder nach bekannten Verfahren hydrophobiert sein. Der Gehalt der erfindungsgemäßen vernetzbaren Siliconzusammensetzungen (X) an aktiv verstärkendem Füllstoff liegt im Bereich von 0 bis 70 Gew.-%, vorzugsweise bei 0 bis 50 Gew.-%.

Besonders bevorzugt sind die vernetzbaren additionsvernetzenden Siliconzusammensetzungen (X) dadurch gekennzeichnet, dass der Füllstoff (E) oberflächenbehandelt ist. Die Oberflächenbehandlung wird durch die im Stand der Technik bekannten Verfahren zur Hydrophobierung feinteiliger Füllstoffe erzielt.

Bevorzugte Füllstoffe (E) weisen infolge einer Oberflächenbehandlung einen Kohlenstoffgehalt von mindestens 0,01 bis maximal 20 Gew.%, bevorzugt zwischen 0.1 und 10 Gew.%, besonders bevorzugt zwischen 0,5 bis 5 Gew.% auf. Besonders bevorzugt sind vernetzbare additionsvernetzende Siliconzusammensetzungen (X) die dadurch gekennzeichnet sind, dass der Füllstoff (E) eine oberflächenbehandelte Kieselsäure, aufweisend 0,01 bis 2 Gew.% Si-gebundene, aliphatisch ungesättigte Gruppen bedeutet. Beispielsweise handelt es sich bei diesen um Si-gebundene Vinylgruppen. In der erfindungsgemäßen additionsvernetzende Siliconzusammensetzungen (X) wird der Bestandteil (E) bevorzugt als einzelne oder ebenfalls bevorzugt als eine Mischung mehrerer feinteiliger Füllstoffe verwendet.

Die erfindungsgemäße additionsvernetzende Siliconzusammensetzung (X) kann wahlweise als Bestandteile weitere Zusätze zu einem Anteil von bis zu 70 Gew.%, vorzugsweise 0,0001 bis 40 Gew.%, enthalten. Diese Zusätze können z.B. inaktive Füllstoffe, harzartige Polyorganosiloxane, die von den Siloxanen (A), (B) und (C) verschieden sind, verstärkende und nicht verstärkende Füllstoffe, Fungizide, Duftstoffe, rheologische Additive, Korrosionsinhibitoren, Oxidationsinhibitoren, Lichtschutzmittel, flammabweisend machende Mittel und Mittel zur Beeinflussung der elektrischen Eigenschaften,Dispergierhilfsmittel, Lösungsmittel, Haftvermittler, Pigmente, Farbstoffe, Weichmacher, organische Polymere, Hitzestabilisatoren usw. sein. Hierzu zählen Zusätze, wie Quarzmehl, Diatomeenerde, Tone, Kreide, Lithopone, Ruße, Graphit, Metalloxide, Metallcarbonate, -sulfate, Metallsalze von Carbonsäuren, Metallstäube, Fasern, wie Glasfasern, Kunststoffasern, Kunststoffpulver, Metallstäube, Farbstoffe, Pigmente usw.

Diese Füllstoffe können zudem wärmeleitend oder elektrisch leitend sein. Beispiele für wärmeleitende Füllstoffe sind Aluminiumnitrid; Aluminumoxid; Bariumtitanat; Berylliumoxid; Bornitrid; Diamant; Grafit; Magnesiumoxid; partikuläres Metall wie beispielsweise Kupfer, Gold, Nickel oder Silber; Siliziumcarbid; Wolframcarbid; Zinkoxid und eine Kombination davon. Wärmeleitende Füllstoffe sind im Stand der Technik bekannt und im Handel erhältlich. Zum Beispiel CB-A20S und Al-43-Me sind Aluminiumoxid-Füllstoffe in verschiedenen Partikelgrößen, die im Handel bei Showa-Denko erhältlich sind, und AA-04, AA-2 und AA1 8 sind Aluminiumoxid-Füllstoffe, die im Handel bei Sumitomo Chemical Company erhältlich sind. Silber-Füllstoffe sind im Handel bei Metalor Technologies U.S.A. Corp. of Attleboro, Massachusetts, U.S.A., erhältlich. Bornitrid-Füllstoffe sind im Handel bei Advanced Ceramics Corporation, Cleveland, Ohio, U.S.A., erhältlich. Zu den Verstärkungsfüllstoffen gehören Silica und Kurzfasern wie beispielsweise KEVLAR-Kurzfaser®. Es können eine Kombination aus Füllstoffen mit verschiedenen Partikelgrößen und unterschiedlicher Partikelgrößenverteilung verwendet werden.

Die additionsvernetzende Siliconzusammensetzungen (X) kann weitere optionale Komponenten enthalten. Zu den Beispielen für weitere optionale Komponenten gehören unter anderem (F) ein oder mehrere Lösungsmittel, (G) ein oder mehrere Inhibitoren.

Die additionsvernetzende Siliconzusammensetzungen (X) kann zusätzlich optional ein Lösungsmittel (F) enthalten. Es ist jedoch darauf zu achten, dass das Lösemittel (F) keine nachteiligen Effekte auf das Gesamtsystem hat. Geeignete Lösungsmittel (F) sind im Stand der Technik bekannt und im Handel erhältlich. Das Lösungsmittel (F) kann beispielsweise ein organisches Lösungsmittel mit 3 bis 20 Kohlenstoffatomen sein. Zu den Beispielen für Lösungsmittel (F) gehören aliphatische Kohlenwasserstoffe wie beispielsweise Nonan, Decalin und Dodecan; aromatische Kohlenwasserstoffe wie beispielsweise Mesitylen, Xylen und Toluen; Ester wie beispielsweise Ethylacetat und Butyrolacton; Ether wie beispielsweise n-Butylether und Polyethylenglycolmonomethylether; Ketone wie beispielsweise Methylisobutylketon und Methylpentylketon; Siliconfluid wie beispielsweise lineare, verzweigte und zyklische Polydimethylsiloxane und Kombinationen aus diesen Lösungsmitteln (F). Die optimale Konzentration eines bestimmten Lösungsmittels (F) in der additionsvernetzenden Siliconzusammensetzung (X) kann durch Routineversuche leicht bestimmt werden. Je nach Gewicht der Verbindung kann die Menge des Lösungsmittels (F) zwischen 0 und 95 Gew.% bzw. zwischen 1 und 95 Gew.% liegen.

Die additionsvernetzende Siliconzusammensetzung (X) kann zusätzlich optional (G) Inhibitoren und Stabilisatoren enthalten. Inhibitoren und Stabilisatoren (G) dienen der gezielten Einstellung der Verarbeitungszeit, Anspringtemperatur und Vernetzungsgeschwindigkeit der erfindungsgemäßen additionsvernetzenden Siliconzusammensetzung (X). Diese Inhibitoren und Stabilisatoren (G) sind auf dem Gebiet der additionsvernetzenden Zusammensetzungen sehr gut bekannt. Beispiele gebräuchlicher Inhibitoren sind acetylenische Alkohole, wie 1-Ethinyl-1-cyclohexanol, 2-Methyl-3-butin-2-ol und 3.5-Dimethyl-1-hexin-3-ol, 3-Methyl-1-dodecin-3-ol, Polymethylvinylcyclosiloxane wie 1,3,5,7-Tetravinyltetramethyltetracyclosiloxan, niedermolekulare Siliconöle mit Methylvinyl-SiO_{1/2}-Gruppen und/oder R₂vinylSiO_{1/2}-Endgruppen, wie Divinyltetramethyldisiloxan Tetravinyldimethyldisiloxan, Trialkylcyanurate, Alkylmaleate, wie Diallylmaleate, Dimethylmaleat und Diethylmaleat, Alkylfumarate, wie Diallylfumarat und Diethylfumarat, organische Hydroperoxide wie Cumolhydroperoxid, tert-Butylhydroperoxid und Pinanhydroperoxid, organische Peroxide, organische Sulfoxide, organische Amine, Diamine und Amide, Phosphane und Phosphite, Nitrile, Triazole, Diaziridine und Oxime. Die Wirkung dieser Inhibitorzusätze (G) hängt von ihrer chemischen Struktur ab, so dass die Konzentration individuell bestimmt werden muss. Inhibitoren und Inhibitormischungen (G) werden vorzugsweise in einem Mengenanteil von 0,00001 Gew.% bis 5 Gew.% bezogen auf das Gesamtgewicht der Mischung zugesetzt, bevorzugt 0,00005 bis 2 Gew.% und besonders bevorzugt 0,0001 bis 1 Gew.%.

Die folgende Aufzählung steht beispielhaft für auf dem Markt kommerziell erhältliche Siliconzusammensetzungen (X), die geeignet sind für die Herstellung dünner Schichten nach dem erfindungsgemäßen Verfahren. Es handelt sich dabei meist um additionsvernetzende Siliconzusammensetzungen (X). Je nach Viskosität der kommerziellen Siliconzusammensetzungen (X) kann für eine bessere Verarbeitbarkeit Lösungsmittel (F) zugegeben werden.

Materialien der WACKER Chemie AG, München: ELASTOSIL^{®} P-Reihe (7010, 7600, 7613, 7161-160, 7616-195, 7618, 7619, 7622, 7623, 7624, 7628, 7629, 7630, 7633, 7636, 7642-220, 7670, 671, 7676, 7682, 7683/15, 7683/25, 7683/47, 7683/50, 7683/55, 7684/60, 7685, 7686, 7687, 7688, 7700, 7710, 7720, 7731, 7742, 7770, 7707 US, 7915, ...) , ELASTOSIL^{®} M-Reihe (4115, 4125, 4370, 4400, 4440, 4441, 4470, 4600, 4601, 4615, 4630, 4635, 4640, 4645, 4641, 4643, 4644, 4670, 4647, 4648, 4670), ELASTOSIL^{®} RT-Reihe (601, 602, 604, 607, 615, 617, 619, 620, 622, 623, 624, 625, 626, 627, 628, 629, 630, 633, 646, 670, 672, 675, 678, 685, ... ), ELASTOSIL^{®} SOLAR-Reihe (2000, 2200, 2202, 3210, ...), LSR: ELASTOSIL^{®} LR-Reihe (3003/03, 3003/05, 3003/10, 3003/20, 3070/20, 3844/20, 3846/20, 3856/20, 3003/30, 3004/30, 3005/30, 3040/30, 3044/30, 3065/30, 3070/30, 3071/30, 3072/30, 3843/30, 3844/30, 3846/30, 3856/30, 3003/40, 3003/50, 3003/60, 3003/70, 3003/80, 3003/85, 3004/40, 3004/50, 3004/60, 3004/70, 3005/40, 3005/50, 3005/60, 3040/40, 3040/50, 3040/60, 3043/40, 3043/50, 3043/60, 3043/70, 3015/70, 3023/60, 3092/65, 3094/60, 3065/50, 3066/40, 3066/60, 3066/80, 3070/40, 3070/50, 3070/60, 3071/40, 3071/50, 3071/60, 3072/40, 3074/60, 3076/70, 3170/40, 3841/50, 3842/40, 3842/50, 3842/60, 3842/70, 3162, ...), ELASTOSIL^{®} FLR-Reihe (3900/40, 3900/60, 3905/40, 3905/60, ...), HTV: ELASTOSIL^{®} R-Reihe, WACKER SILGEL^{®}-Reihe (610, 611, 612, 613, 616, 619, ...), SEMICOSIL^{®}-Reihe, POWERSIL^{®}-Reihe, LUMISIL^{®}-Reihe, GENIOMER^{®}-Reihe, SILPURAN^{®}-Reihe, DEHESIVE^{®}-Reihe.

Manchmal ist eine Vorbehandlung des Trägers als zusätzlicher Prozessschritt ia) von Vorteil.

Erfolgt eine Vorbehandlung so kann dieser schritt ia) beispielsweise über eine Tauchbehandlung des Trägers erfolgen. Andere chemische oder physikalische Vorbehandlungsmethoden sind ebenfalls möglich, Beispiele hierfür sind: Sprühbehandlung, Reinigungsverfahren, Entfettungsverfahren, Plasmabehandlung oder die Abscheidung von Schichten (Bsp.: Fluorkohlenstoffschichten). Ob ein Vorbehandlungsschritt ia) notwendig oder sinnvoll ist, hängt vom verwendeten Trägermaterial ab. Sollte eine zu starke chemische oder physikalische Anhaftung des Siliconelastomers auf dem verwendeten Trägermaterial ein Ablösen der Folie vom Träger nach der Vernetzung nicht ermöglichen, kann dies durch Vorbehandlung des Trägers verhindert werden. Um das Trennen der Siliconfolie vom Träger zu erleichtern erfolgt bevorzugt die Behandlung des Trägers mit einem Trennmittel, wobei alle dem Stand der Technik bekannten Trennmittel verwendet werden können, wie zum Beispiel: Detergentien wie nichtionische Tenside (Polyalkylenglycolether, Alkylglucoside, Fettalkoholpropylate, Alkylpolyglucoside, Oktylphenolethoxylate, Nonylphenolethoxylate), anionische Tenside (Alkylcarboxylate, Alkylbenzolsulfonate, Fettalkoholsulfate), kationische Tenside (meist quartäre Ammoniumverbindungen wie Tetraalkylammoniumhalogenide oder Esterquats) oder amphotere Tenside (Betaine, Sulfobetaine). Es können alle handelsüblichen Tenside oder Tensidmischungen für eine Vorbehandlung verwendet werden, wie z.B. die Surfynol^{®}-Serie, die Dynol^{™}-Serie, die EnviroGem^{®}-Serie, die Leunapon F-Serie, die Leunapon FU-Serie, die Leunapon P-Serie, die Metaupon-Serie, die Hansanol AS 240-Serie, die Hansanol NS-242 Serie, die Hansanol NS 243-Serie, die Hansanol NS 252-Serie, die Hansanol NS-262-Serie, die Hansanyl OS-Serie, die Hansanid CFAD, die Hansanolat FA-Serie, die Hansanolat NP-Serie, die Hansateric CAPB-Serie, die Cremophor^{®}-Serie, die Eusapon^{®}-Serie, die Jordapon^{®}-Serie, die AVANEL-Serie, die Lutensit^{®}-Serie, die Lutensol-Serie, die Pluracare^{®}-Serie, die Plurafac^{®}-Serie oder die Pluronic-Serie. Das Trennmittel oder eine Mischung verschiedener Trennmittel und Additive wird vorzugsweise in einer wässrigen, einer alkoholischen, oder einer wässrig-alkoholischen Mischung eingesetzt, wobei als Alkoholkomponente bevorzugt lineare und verzweigte aliphatische Alkohole wie z.B. Methanol, Ethanol, Propanol, Butanol, Pentanol, Hexanol, Heptanol, Octanol, Isopropanol, Isobutanol, etc. Verwendung finden.

Vor dem Aufbringen der Siliconzusammensetzung (X) auf den Träger ist es bevorzugt, das überschüssige Vorbehandlungsmaterial wieder vom Träger zu entfernen, was bevorzugt mit Hilfe von Quetsch- und/oder Polierwalzen und/oder Polierteller erfolgt. Anordnung, Größe, Geschwindigkeit oder Anzahl der verwendeten Aggregate spielen nur eine untergeordnete Rolle. Bevorzugt ist außerdem die Verwendung mindestens einer Polierwalze bzw. eines Poliertellers, besonders bevorzugt ist die Verwendung einer Kombination aus Quetsch- und Polierwalzen.

Die Schlitzdüse in Schritt i) steht in einem Winkel zwischen 10° und 90° zum Träger. Bevorzugt sind Winkel zwischen 30° und 90° und besonders bevorzugt Winkel zwischen 50° und 90°.

In einer bevorzugten Ausführungsform ist der Abstand der Schlitzdüse zum Träger in Schritt i) mindestens 2 µm, bevorzugt mindestens 5 µm, größer als die Schichtdicke der hergestellten Siliconfolie.

Die Fahrweise der Schlitzdüse spielt für die Berechnungen der Schichtdicken keine Rolle, da es sich um ein vordosiertes Verfahren handelt (bead mode, curtain mode, short curtain mode). Bei Bedarf kann an die Schlitzdüse ein Unterdruck angelegt werden, um die Fahrweise bei der angegebenen Geschwindigkeit zu erreichen. Der Massenstrom der Siliconzusammensetzung (X) wird über geeignete Pumpen, wie z.B. Zahnradpumpen, Kolbenpumpen, Membranpumpen, etc. erzeugt und eingestellt.

Die Aktivierung zur Vernetzung im Schritt ii) kann thermisch, über IR-Strahlung oder über UV-Strahlung erfolgen. Bei raumtemperaturvernetzenden Systemen ist die Zimmertemperatur für die Aushärtung ausreichend, so dass keine zusätzliche Zufuhr von Energie erfolgen muss. Auch eine Mikrowellenaktivierung oder Aktivierung durch Ultraschall ist möglich.

Bei UV-vernetzenden Systemen wird der Katalysator (D) der Hydrosilylierungsreaktion der additionsvernetzenden Siliconzusammensetzung (X) durch Bestrahlung aktiviert um eine Vernetzung zu erreichen. Es können alle dem Stand der Technik bekannten Lichtquellen wie zum Beispiel LED, Quecksilberdampflampen, dotierte Quecksilberdampflampen, Xenonlampen oder Laser verwendet werden. Vorzugsweise werden Wellenlängen zwischen 250 und 800 nm eingestrahlt, besonders bevorzugt sind Wellenlängen zwischen 300 und 500 nm. Die Anordnung der Lichtquellen ist beliebig, wobei der Abstand zwischen der Lichtquelle und der zu vernetzenden Siliconzusammensetzung (X) zwischen wenigen Millimetern und mehreren Zentimetern variieren kann.

Im einfachsten Fall wird die in Schritt ii) gebildete Siliconfolie direkt mit dem Träger gesammelt. Weitere Möglichkeiten bestehen darin die Siliconfolie in einem Schritt iii) vom Träger zu trennen und sie dann zu sammeln, oder vom Träger auf einen anderen Träger zu übertragen und dann zusammen mit dem anderen Träger zu sammeln.

Gründe für die Notwendigkeit der Übertragung auf einen anderen Träger können z.B. die mangelhafte thermische oder UV-Beständigkeit des Trägers , Preisdifferenzen zwischen den Trägermaterialien, Oberflächeneigenschaften, Oberflächengüten, Dicke, Gewicht, etc. sein. Der Schritt des Trägerwechsels hat keinerlei Einfluss auf die anderen Prozessschritte.

Anschließend kann die so gesammelte Siliconfolie entweder direkt weiterverarbeitet oder bis zur weiteren Verwendung gelagert werden. Wird erst im Zuge der Weiterverarbeitung der Träger von der Siliconfolie entfernt, kann der Zeitpunkt (ob vor oder nach der Weiterverarbeitung) eine Rolle spielen. Die weitere Verarbeitung der Folie kann mit allen dem Stand der Technik bekannten Verfahren erfolgen, beispielsweise für die Formgebung der Siliconfolie, um diese in der gewünschten Anwendung einsetzen zu können. Beispiele hierfür, ohne die Erfindung zu beschränken, sind schneiden mit diversen Methoden wie Messer, Laser, Wasser oder Partikelstrahl oder stanzen. Auch ein Fixieren durch beispielsweise Kleben, etc. ist möglich.

Ein weitere Gegenstand sind Siliconfolien hergestellt mit dem erfindungsgemäßen Verfahren, mit einer Foliendicke von 0,1 bis 200 µm, bevorzugt von 1 bis 150 µm und besonders bevorzugt von 2 bis 100 µm und jeweils einer Dickengenauigkeit von ±5 % gemessen auf einer Fläche von 200 cm²; bevorzugt eine Dickengenauigkeit von jeweils ±3%.

Die mit dem beschriebenen erfindungsgemäßen Verfahren hergestellten Siliconfolien haben weiterhin den Vorteil, dass sie als dielektrische elektroaktive Polymere (EAP) in Aktoren, Sensoren oder Generatoren verwendet werden können, da ihre Durchschlagsspannung größer als 25 kV/mm, bevorzugt größer als 30 kV/mm und besonders bevorzugt größer als 35 kV/mm ist.

Besonders bei Anwendungen der EAPs im Bereich der Aktoren oder der Generatoren werden im Verlauf der Lebensdauer mehrere Millionen Schwingungszyklen durchlaufen. Ein Vorteil der mit Hilfe des erfindungsgemäßen Verfahrens hergestellten Siliconfolien ist eine sehr hohe Dauerbelastungsbeständigkeit, welche durch die Gleichmäßigkeit und Partikelfreiheit der Siliconfolie bedingt wird. Für die Auslegung der Betriebsspannung der Bauteile sind die oben genannten Eigenschaften ebenfalls von größter Bedeutung, da sie einen direkten Einfluss auf die Durchbruchfeldstärke besitzen. Das maximale elektrische Feld wiederum hat einen direkten Einfluss auf den Wirkungsgrad und die Performance der Aktoren oder Generatoren.

Gleichmäßigkeit bedeutet, dass die Schichtdicke auf einer bestimmten Fläche nur minimal variiert. Bei Siliconfolien, die mit dem erfindungsgemäßen Verfahren hergestellt werden, variiert die Schichtdicke maximal um ±5% innerhalb einer Fläche von 200 cm² (=Dickengenauigkeit). Das bedeute, dass beispielsweise eine Folie mit einer mittleren Schichtdicke von 100 µm, auf einer Fläche von 200 cm² keine Stelle aufweist, an der die Schichtdicke kleiner als 95 µm oder größer als 105 µm ist. Oder anders gesagt, eine Folie mit einer mittleren Schichtdicke von 100 µm und einer Dickengenauigkeit von ±5% weist über die gesamte Fläche von 200 cm² stets eine Dicke von mindestens 95 und höchstens 105 µm auf egal wo auf der 200 cm² Fläche die Schichtdicke bestimmt wird.

Mit Hilfe des beschriebenen Verfahrens können neben Siliconfolien auch Multi-Layer-Strukturen aufgebaut werden, wobei mindestens eine Schicht eine erfindungsgemäße Siliconfolie darstellt.

Je nach Anwendung ist eine Vielzahl von Anordnungen oder Aufbauten derartiger Systeme denkbar, welche durch stapeln, falten, aufrollen, etc. erreicht werden können.

Weitere Anwendungen der mit dem beanspruchten Verfahren hergestellten Folien sind: Barrierefolien im Medizin- oder Lebensmittelbereich, Isolierbänder, Schutzfolien (Tastaturen, Hautschutz, Mundschutz, Glas/Kratzschutz für diverse Materialie), Verpackungen aller Art (Lebensmittel, Pflanzen), Trägerfolien für Wundauflagen, Funktionsschichten in Kleidung, Stoff- oder Gastrennungsschicht (Gastrennung, Meerwasserentsalzung, ...), Trägerfolie, Koch- bzw. Garfolie, Folien für Display-Anwendungen, Airbags oder Weinkorken.

### Beispiele:

In den nachstehend beschriebenen Beispielen beziehen sich alle Angaben von Teilen und Prozentsätzen, falls nicht anders angegeben, auf das Gewicht. Sofern nicht anders angegeben, werden die nachstehenden Beispiele bei einem Druck der umgebenden Atmosphäre, also etwa bei 1000 hPa, und bei Raumtemperatur, also bei 25 °C, bzw. bei einer Temperatur, die sich beim Zusammengeben der Reaktanden bei Raumtemperatur ohne zusätzliche Heizung oder Kühlung einstellt, durchgeführt. Im Folgenden beziehen sich alle Viskositätsangaben auf eine Temperatur von 25 °C. Die nachfolgenden Beispiele erläutern die Erfindung, ohne dabei beschränkend zu wirken.

In den Beispielen wurde als Träger ein PET (Polyethylenterephthalat) Film der Firma Mitsubishi Polymer Film GmbH verwendet (HOSTAPHAN^{®}). Derartige Folien sind auch von anderen Herstellern erhältlich, zum Beispiel MYLAR^{®} (DuPont Teijin Films), MELINEX^{®} (DuPont Teijin Films), SCOTCHPAK^{®} (3M Company, St. Paul, MN).

Es wurde eine Schlitzdüse der Fa. COATEMA Coating Machinery GmbH verwendet, wobei die Art der Schlitzdüse für die Herstellung keine entscheidende Rolle spielt. Alternativ können auch Schlitzdüsen anderer Hersteller (Fa. FMP Technology GmbH, Mitsubishi Heavy Industries, etc.) verwendet werden.
Die absolute Schichtdicke wird mit Hilfe einer REM-Analyse eines Kryoschnitts bestimmt, die Oberflächengüte und Rauhigkeit werden mit Hilfe des Konfokal-Mikroskops Leica DCM 3D ermittelt.

Es werden folgende Abkürzungen verwendet:
- Bsp.: Beispiel
- Nr.: Nummer
- PDMS: Polydimethylsiloxan
- LSR: Liquid Silicone Rubber
- HTV: Hochtemperaturvernetzend
- Gew.%: Gewichtsprozent, w/w
- U_{w}: Substrat- oder Bahngeschwindigkeit
- p: Dichte
- h: Nassfilmdicke
- B: Beschichtungsbreite

Die Beispiele 1 bis 5 wurden mit einem Verfahren gemäß Figur 1 durchgeführt, wobei die Position A der Schlitzdüse gewählt wurde. In Beispiel 6 (Vergleichsbeispiel, nicht erfindungsgemäß) erfolgte der Auftrag der Siliconzusammensetzung mit Hilfe eines Kastenrakels. Die Beispiele 7 bis 10 wurden mit einem Verfahren gemäß Figur 3 durchgeführt, wobei die Position A der Schlitzdüse gewählt wurde.

### Beispiel 1: (ohne Vorbehandlung)

Herstellung einer 50 µm dicken Folie aus dem RTV-2 Material ELASTOSIL^{®} P 7670 A/B (Mischungsverhältnis A:B = 1:1, Dichte nach ISO 2811 = 1,03 g/cm³, Härte Shore A nach ISO 868 = 7, Reißdehnung nach ISO 37 = 600 %, Reißfestigkeit nach ISO 37 = 1,8 N/mm², Viskosität nach Mischen der Komponenten nach ISO 3219 = 1800 mPa•s bei einer Scherung von 1 s⁻¹, Weiterreißwiderstand nach ASTM D 624 B = 2,1 N/mm).
Um eine Nassfilmdicke von 50 µm bei einer Bahngeschwindigkeit von 1 m/min und einer Schichtbreite von 0,3 m bei der gegebenen Dichte einzustellen, liegt die Fördermenge bei 15,45 ml/min.
Gemessene Schichtdicke/Oberflächenrauhigkeit: 50 ± 1,5 µm Durchschlagsspannung nach ASTM D 3755: 35 kV/mm

### Beispiel 2: (ohne Vorbehandlung)

Herstellung einer 20 µm dicken Folie aus dem RTV-2 Material ELASTOSIL^{®} P 7684/60 A/B (Mischungsverhältnis A:B = 1:1, Dichte nach ISO 2811 = 1,08 g/cm³, Härte Shore A nach ISO 868 = 12, Reißdehnung nach ISO 37 = 600 %, Reißfestigkeit nach ISO 37 = 3 N/mm², Viskosität nach Mischen der Komponenten nach ISO 3219 = 1500 mPa•s bei einer Scherung von 1 s⁻¹, Weiterreißwiderstand nach ASTM D 624 B = 13 N/mm).
Um eine Nassfilmdicke von 20 µm bei einer Bahngeschwindigkeit von 2 m/min und einer Schichtbreite von 0,3 m bei der gegebenen Dichte einzustellen, liegt die Fördermenge bei 32,4 ml/min.
Gemessene Schichtdicke/Oberflächenrauhigkeit: 20 ± 1 µm Durchschlagsspannung nach ASTM D 3755: 50 kV/mm

### Beispiel 3: (ohne Vorbehandlung)

Herstellung einer 100 µm dicken Folie aus dem RTV-2 Material, das ELASTOSIL^{®} LR 3003/40, nach oder vor dem Mischen der Komponente verdünnt auf einen Lösungsmittelanteil von 50 Vol% (Alkanfraktion, Handelsname ISOPAR-E), (Mischungsverhältnis A:B = 1:1, Dichte nach ISO 2811 = 1,0 g/cm³, Härte Shore A nach ISO 868 = 42, Reißdehnung nach ISO 37 = 610 %, Reißfestigkeit nach ISO 37 = 10 N/mm², Weiterreißwiderstand nach ASTM D 624 B = 33 N/mm, Viskosität nach Mischen der Komponenten nach ISO 3219 = 5300 mPa•s bei einer Scherung von 1 s⁻¹).
Für eine Schichtdicke des Elastomers von 100 µm ist bei 50 Vol% Lösungsmittelanteil und einer Nassfilmdicke von 200 µm bei einer Bahngeschwindigkeit von 5 m/min und einer Schichtbreite von 0,3 m bei der gegebenen Dichte eine Fördermenge von 300 ml/min notwendig. Das Lösungsmittel wird vor der Vernetzung abgedampft. Wie dieser Prozess im Detail gefahren wird, spielt für die herzustellende Folie keine Rolle. In diesem Beispiel wird die Bahn durch einen 3 m langen Trockenofen mit drei verschiedenen Temperaturzonen (erster Meter = 120 °C, zweiter Meter = 140 °C, dritter Meter = 165 °C) gefahren um zuerst das Lösungsmittel abzudampfen und danach durch die erhöhte Temperatur eine Vernetzung des Materials zu erzielen. Gemessene Schichtdicke/Oberflächenrauhigkeit: 100 ± 3 µm Durchschlagsspannung nach ASTM D 3755: 40 kV/mm

### Beispiel 4: (ohne Vorbehandlung)

Das Material aus Beispiel 3 wurde mit einer Bahngeschwindigkeit von 30 m/min und dementsprechend einer Fördermenge von 1800 ml/min gefahren.
Gemessene Schichtdicke/Oberflächenrauhigkeit: 100 ± 4 µm Durchschlagsspannung nach ASTM D 3755: 40 kV/mm

### Beispiel 5: (ohne Vorbehandlung)

Herstellung einer 20 µm dicken Folie aus einem Silicon mit der Zusammensetzung:
49 Gew.% eines vinylterminierten, linearen Polydimethylsiloxans mit einer mittleren Kettenlänge von ca. 220.
23 Gew.% eines Me₂Si-H-terminierten, linearen Polydimethylsiloxans mit einer mittleren Kettenlänge von ca. 220.
23 Gew.% einer hydrophobierten, pyrogenen Kieselsäure mit einer BET-Oberfläche von 130 m²/g
5 Gew.% eines linearen Kammvernetzers mit einer Kettenlänge von ca. 220 Einheiten und einem Si-H-Gehalt von 0,15 Gew%
Die Mischung enthält zudem
10 ppm Platinkatalysator (Divinyltetramethyldisiloxankomplexe, bezogen auf das Metall)
250 ppm 1-Ethinylcyclohexanol zur Einstellung der Topfzeit.

Härte Shore A nach ISO 868 = 26, Dichte nach ISO 2811 = 1,05 g/cm³, Reißdehnung nach ISO 37 = 490 %, Reißfestigkeit nach ISO 37 = 5,9 N/mm², Weiterreißwiderstand nach ASTM D 624 B = 11,6 N/mm, Viskosität nach ISO 3219 = 6900 mPa•s bei einer Scherung von 1 s⁻¹.
Um eine Nassfilmdicke von 20 µm bei einer Bahngeschwindigkeit von 10 m/min und einer Schichtbreite von 0,3 m bei der gegebenen Dichte einzustellen, liegt die Fördermenge bei 63 ml/min. Gemessene Schichtdicke/Oberflächenrauhigkeit: 20 ± 0,8 µm Durchschlagsspannung nach ASTM D 3755: >75 kV/mm

Beispiel 6: (Vergleichsbeispiel, nicht erfindungsgemäß) Herstellung einer 50 µm dicken Folie aus dem RTV-2 Material ELASTOSIL^{®} P 7670 A/B (Mischungsverhältnis A:B = 1:1, Dichte nach ISO 2811 = 1,03 g/cm³, Härte Shore A nach ISO 868 = 7, Reißdehnung nach ISO 37 = 600 %, Reißfestigkeit nach ISO 37 = 1,8 N/mm², Viskosität nach Mischen der Komponenten nach ISO 3219 = 1800 mPa•s bei einer Scherung von 1 s⁻¹, Weiterreißwiderstand nach ASTM D 624 B = 2,1 N/mm).
Die Einstellung der Schichtdicke auf 50 µm erfolgt durch manuelles Anpassen des Abstands zwischen dem verwendeten Kastenrakel und der Bahn.
Gemessene Schichtdicke/Oberflächenrauhigkeit: 50 ± 6 µm Durchschlagsspannung nach ASTM D 3755: 22 kV/mm

### Beispiel 7: (mit Vorbehandlung)

Das Tauchbad in Figur 3 wird mit einer Lösung aus 2 Gew.% der handelsüblichen Tensidmischung Green Care No 5 der Firma Tana Chemie GmbH in Wasser verwendet. Die Rotationsgeschwindigkeit der Quetschwalzen ist gleich der Bahngeschwindigkeit, die der Polierwalzen ist das Fünffache der Bahngeschwindigkeit. Herstellung einer 50 µm dicken Folie aus dem RTV-2 Material ELASTOSIL^{®} P 7670 A/B (Mischungsverhältnis A:B = 1:1, Dichte nach ISO 2811 = 1,03 g/cm³, Härte Shore A nach ISO 868 = 7, Reißdehnung nach ISO 37 = 600 %, Reißfestigkeit nach ISO 37 = 1,8 N/mm², Viskosität nach Mischen der Komponenten nach ISO 3219 = 1800 mPa•s bei einer Scherung von 1 s⁻¹, Weiterreißwiderstand nach ASTM D 624 B = 2,1 N/mm).
Um eine Nassfilmdicke von 50 µm bei einer Bahngeschwindigkeit von 1 m/min und einer Schichtbreite von 0,3 m bei der gegebenen Dichte einzustellen, liegt die Fördermenge bei 15,45 ml/min.
Gemessene Schichtdicke/Oberflächenrauhigkeit: 50 ± 1,5 µm Durchschlagsspannung nach ASTM D 3755: 35 kV/mm

### Beispiel 8: (mit Vorbehandlung)

Das Tauchbad in Figur 3 wird mit einer Lösung aus 2 Gew% der handelsüblichen Tensidmischung Green Care No 5 der Firma Tana Chemie GmbH in Wasser verwendet. Die Rotationsgeschwindigkeit der Quetschwalzen ist gleich der Bahngeschwindigkeit, die der Polierwalzen ist das Fünffache der Bahngeschwindigkeit. Herstellung einer 20 µm dicken Folie aus einem Silicon mit der Zusammensetzung:
35 Gew.% eines vinylterminierten, linearen Polydimethylsiloxans mit einer mittleren Kettenlänge von ca. 600.
15 Gew.% eines vinylterminierten, linearen Polydimethylsiloxans mit einer mittleren Kettenlänge von ca. 220.
50 Gew.% eines linearen Kammvernetzers, Me₂SiH-terminiert, mit einer Kettenlänge von ca. 220 Einheiten und einem Si-H-Gehalt von 0,015 Gew.%
Die Mischung enthält zudem
10 ppm Platinkatalysator (Divinyltetramethyldisiloxankomplexe, bezogen auf das Metall)
250 ppm 1-Ethinylcyclohexanol zur Einstellung der Topfzeit.

Härte Shore A nach ISO 868 = 2, Dichte nach ISO 2811 = 0,97 g/cm³, Reißdehnung nach ISO 37 = 350 %, Reißfestigkeit nach ISO 37 = 1,9 N/mm², Weiterreißwiderstand nach ASTM D 624 B = 2,6 N/mm, Viskosität nach ISO 3219 = 3500 mPa•s bei einer Scherung von 1 s⁻¹.
Um eine Nassfilmdicke von 20 µm bei einer Bahngeschwindigkeit von 10 m/min und einer Schichtbreite von 0,3 m bei der gegebenen Dichte einzustellen, liegt die Fördermenge bei 64,02 ml/min.
Gemessene Schichtdicke/Oberflächenrauhigkeit: 20 ± 1 µm Durchschlagsspannung nach ASTM D 3755: 35 kV/mm

### Beispiel 9: (mit Vorbehandlung)

Das Tauchbad in Figur 3 wird mit einer Lösung aus 2 Gew% der handelsüblichen Tensidmischung Green Care No 5 der Firma Tana Chemie GmbH in Wasser verwendet. Die Rotationsgeschwindigkeit der Quetschwalzen ist gleich der Bahngeschwindigkeit, die der Polierwalzen ist das Fünffache der Bahngeschwindigkeit. Herstellung einer 0,5 µm dicken Folie aus einem Silicon mit der Zusammensetzung:
49 Gew.% eines vinylterminierten, linearen Polydimethylsiloxans mit einer mittleren Kettenlänge von ca. 220.
23 Gew.% eines Me₂Si-H-terminierten, linearen Polydimethylsiloxans mit einer mittleren Kettenlänge von ca. 220.
23 Gew.% einer hydrophobierten, pyrogenen Kieselsäure mit einer BET-Oberfläche von 130 m²/g
5 Gew.% eines linearen Kammvernetzers mit einer Kettenlänge von ca. 220 Einheiten und einem Si-H-Gehalt von 0,15 Gew%
Die Mischung enthält zudem
10 ppm Platinkatalysator (Divinyltetramethyldisiloxankomplexe, bezogen auf das Metall)
250 ppm 1-Ethinylcyclohexanol zur Einstellung der Topfzeit. Vor der Auftragung werden 1 1 Mischung mit 3 1 Lösungsmittel (Alkanfraktion, Handelsname Isopar E) verdünnt, die Dichte der Lösung liegt bei 0,98 g/cm³, die Viskosität der Lösung nach ISO 3219 = 30 mPa•s bei einer Scherung von 1 s⁻¹.

Härte Shore A nach ISO 868 = 26, Dichte des Elastomers nach ISO 2811 = 1,05 g/cm³, Reißdehnung nach ISO 37 = 490 %, Reißfestigkeit nach ISO 37 = 5,9 N/mm², Weiterreißwiderstand nach ASTM D 624 B = 11,6 N/mm, Viskosität nach ISO 3219 = 6900 mPa•s bei einer Scherung von 1 s⁻¹.
Um eine Nassfilmdicke von 2 µm bei einer Bahngeschwindigkeit von 1 m/min und einer Schichtbreite von 0,3 m bei der gegebenen Dichte einzustellen, liegt die Fördermenge bei 0,588 ml/min.
Gemessene Schichtdicke/Oberflächenrauhigkeit: 0,5 ± 0,02 µm Durchschlagsspannung nach ASTM D 3755: 85 kV/mm

## Patentansprüche

1. Verfahren zur kontinuierlichen Herstellung dünner Siliconfolien mit einer Foliendicke von 0,1 bis 200 µm, und einer Dickengenauigkeit von ±5 % gemessen auf einer Fläche von 200 cm²,
**dadurch gekennzeichnet, dass**
i) eine lösungsmittelhaltige oder lösungsmittelfreie, vernetzbare Siliconzusammensetzung (X) durch den Spalt einer Schlitzdüse auf einen sich bewegenden Träger aufgetragen wird,
ii) anschließend aus der Siliconschicht, welche sich auf der Trägerfolie ausbildet das Lösungsmittel, falls vorhanden, entfernt und die Siliconschicht vernetzt wird,
iii) nach der Vernetzung die entstandene Siliconfolie vom Träger getrennt werden kann,
mit folgenden Maßgaben:
- die Schlitzdüse in Schritt i) steht in einem Winkel zwischen 10° und 90° zum Träger;
- die Laufgeschwindigkeit des Trägers liegt zwischen 0,1 und 1000 m/min;
- die dynamische Viskosität gemessen nach DIN53019 der Siliconzusammensetzung (X) liegt zwischen 100 mPa•s und 100 Pa•s.

## Claims

1. Method for continuous production of thin silicone films having a film thickness of 0.1 to 200 µm and a thickness precision of ±5% measured over an area of 200 cm²,
**characterized in that**
i) a crosslinkable, solvent-containing or solvent-free silicone composition (X) is applied through the gap of a slot die to a moving carrier,
ii) subsequently the solvent, if present, is removed from the silicone layer which forms on the carrier film, and the silicone layer is crosslinked,
iii) after the crosslinking, the resulting silicone film can be parted from the carrier,
with the following provisos:
- the slot die in step i) is at an angle of between 10° and 90° to the carrier;
- the travel speed of the carrier is between 0.1 and 1000 m/min;
- the dynamic viscosity of the silicone composition (X) as measured according to DIN53019 is between 100 mPa•s and 100 Pa•s.

## Revendications

1. Procédé de production continue de films minces de silicone, ayant une épaisseur de film de 0,1 à 200 µm, et une précision d'épaisseur de ±5 %, mesurée sur une surface de 200 cm²,
**caractérisé en ce que**
i) une composition de silicone réticulable (X), contenant un solvant ou exempte de solvant, est appliquée par la fente d'une buse à fente sur un support en mouvement,
ii) ensuite, le solvant, s'il est présent, est enlevé de la couche de silicone qui se forme sur le film support et la couche de silicone est réticulée,
iii) après la réticulation, le film de silicone restant peut être séparé du support,
avec les conditions suivantes :
- la buse à fente à l'étape i) est orientée suivant un angle compris entre 10° et 90° par rapport au support ;
- la vitesse d'avance du support est comprise entre 0,1 et 1000 m/min ;
- la viscosité dynamique, mesurée selon DIN53019, de la composition de silicone (X) est comprise entre 100 mPa•s et 100 Pa•s.
